# EUROPEAN PATENT APPLICATION

(11) **EP 3 582 595 A1**
(43) Date of publication of application: **18.12.2019**
(21) Application number: 18177241.9
(22) Date of filing: 12.06.2018
(51) Int. Cl.: H05K 7/14

(54) **PART ASSEMBLY HOUSING**

(71) Applicant: Visteon Global Technologies, Inc., Van Buren Township, Michigan 48111 (US)
(72) Inventor: MICHEV, Mihail Miroslavov, 1715 Sofia (BG); IVANOV, Nikola Vasilev, 1164 Sofia, (BG)
(74) Representative: MERH-IP Matias Erny Reichl Hoffmann Patentanwälte PartG mbB

(57) **Abstract**

A part assembly housing 1 and a method of assembling a part assembly housing 1 comprising a first housing part at or in which at least a first part to be fixed to the first housing part 2 is provided and a second housing part 3 comprising at least a first fixation part 6 for fixing the first part 4, the second housing part 3 being configured to be fastened to the first housing part 2 by a fastener 8, wherein the second housing part 3 has a structure to generate a resilient force acting on the first part 4 via the first fixation part 6 in such a manner that the first part 4 is fixed in its position at or in the first housing part 2, when the second housing part 3 is fastened to the first housing part 2 by the fastener 8.

## Description

### TECHNICAL FIELD

The present application relates to a part assembly housing and a method for assembling a part assembly housing which allow an improved fixing of parts to be mounted thereto, in particular during assembling of electronic components to a housing of modules, displays, boxes or the like. The part assembly housing according to the one or more embodiments may be a housing for mounting thereto electronic parts, such as a printed wiring circuit board (PWB) or the like.

### BACKGROUND

When assembling electronic mass products, such as electronic modules, displays, etc., besides the aspect of mass production to assemble a high number of electronic parts or components to the housing in a given time cycle efficiently, tolerances for mounting the electronic parts at respective positions are of crucial importance to meet the high requirements regarding failure safety and to avoid high rates of rejected parts which, in subsequent function tests, turn out not to comply with the required functions and/or the required tolerances to be kept during mass production.

In the art, a common approach during the assembling of electronic boxes with PWBs is to simply fix, for example, two PWBs inside an electronic box part by part by means of screws.

Mounting of electronic parts to a housing by means of screws may be cumbersome and time-consuming, especially when more than one part needs to be mounted inside the housing because this requires to first position a first PWB inside the housing, screwing it to the housing and then to place a second PWB inside the housing, and screwing it thereto, repeatedly.

### BRIEF SUMMARY OF THE INVENTION

At least in view of the shortcomings appearing from the above description of the art, the present application proposes an improved part assembly housing and a relating method which facilitate the assembling process of, in particular, but not limiting thereto, electronic parts like PWBs, etc. to a housing.

In one or more embodiments, a part assembly housing according to an aspect comprises a first housing part at or in which a first part to be fixed to the first housing part is provided, a second housing part comprising a first fixation part for contacting the first part, the second housing part being configured to be fastened to the first housing part by a fastener, wherein the second housing part has a structure to generate a resilient force acting on the first part via the first fixation part in such a manner that the first part is fixed in its position at or in the first housing part, when the second housing part is fastened to the first housing part by the fastener.

According to this aspect, the second housing part is structured to generate a resilient force acting on the first part to be mounted via the first fixation part in such a manner that the fixed part is fixed in its position at or inside the first housing part, when the second housing part is fastened to the first housing part by the fastener. As a result, an indirect fixing is realized, as it is not necessary to fix the first part itself to the housing by screws or other fastening means but indirectly through the operation of a fastener which results in an elastic deformation of the second housing part, the resulting force in terms of stresses being transferred onto the part to be fixed in or at the first housing part by means of the fixation part attached to the second housing part.

An advantage of such a structure is that resilient forces are generated without the need to use additional components, such as springs and the like. This is of particular advantage when the assembly housing is made of magnesium or other metals/plastics/composites which do not allow for the formation of complex shaped parts like a spring due to material properties like brittleness or the like, or processing difficulties.

According to an aspect, when assembling the housing, the first part may be placed at or in the first housing part in such a manner that the first fixation part is in contact with the first part at the time when the second housing part is fastened to the first housing part by starting to operate the fastener.

According to such a configuration, it is possible to pre-mount the first part at or inside the first housing part still before the fastening process is started by operating the fastener. Thereby, the position where the first part has to be fixed at or in the first housing part can be, at least to a certain extent, predetermined in the automated assembling process in such a manner that a pre-fixture is realized still before starting the fastening process to ultimately fix the part in its position by operating the fastener. As a consequence, the positioning process of the PWB, for example, inside the housing part can be carried out more accurately, without the use of additional fastening means.

According to an aspect, the fastener is structured such that the force exerted by the fastener onto the second housing part is increased gradually by operating the fastener during the fastening process, whereby the second housing part is continuously deformed to increase the resilient force acting on the first part to be fixed.

According to an aspect, the material of the second housing part is suitably selected from metal, plastics, composites according to the particular requirements and demands of the respective application case, like the environment temperature and required forces to allow for an elastic deformation of the second housing part to generate the required resilient force acting on the first part via the first fixation part. For example, in a highly corrosive environment higher forces need to be applied to the part to be fixed by use of the second housing, since material degradation may lead to a reduction of the resulting resilient force to keep the first part in its position reliably over the lifetime of the housing.

Since the part housing is structured in such a manner that the fastening force exerted by the fastener onto the second housing part is increased gradually by operating the fastener during the fastening process, the resulting resilient forces may be exactly tailored by material selection and construction of the relating parts to the specific requirements of the respective application conditions which enables a very broad range of application scenarios.

A configuration according to this aspect can be easily realized when the fastener is constituted by a screw continuously screwed through a through-hole in the second housing part into a counter hole provided at the first housing part, whereby the second housing part is prefixed in a position with a gap to the first housing part at the time before the deformation of the second housing part occurs due to the operation of the fastener by turning the screw into the counter hole.

With such a structure of a part assembly housing according to this aspect, it becomes possible to continuously decrease the gap between the second housing part and the first housing part. By this operation, the deformation of the second housing part is proceeding continuously. The fixation part(s) is arranged at such positions that it is coming into contact with the part(s) to be fixed inside the housing with increasing deformation of the second housing part. Here, the use of a screw to reduce the distance between the second housing part and the first housing part is just an example. Any fastening parts may be used to continuously increase the tensile stress or compressive stress acting on the second housing part to increase its elastic deformation according to such an embodiment.

According to this aspect, the fixation part is arranged at a position of the second housing which is subject to a movement when the second housing part is elastically deformed so that the bending results in a movement of the fixation part which is necessary to apply a compressive tension on the part(s) to be fixed.

According to an aspect, the second housing part has a lower young's modulus than the first housing part and/or the first part to be fixed to the first housing part. With such a configuration, the part housing is structured such that the gap between the first housing part and the second housing part is closed by bringing the second housing part into contact with the first housing part by continuously bending the second housing part. Since the structure of the first part and/or the first housing part exhibit(s) a higher young's modulus than the second housing part, it is ensured that the second housing part is deformed and the entire resilient force resulting from the bending process is applied to the part to be fixed at or in the first housing part, because no energy is consumed by deformation of the first housing part and/or the first part.

The same applies to the material properties of the first fixation part in comparison to the second housing part, which exhibits a higher young's modulus to avoid any unnecessary deformation when receiving the resilient force resulting from the bending of the second housing part.

According to an aspect, the second housing part may comprise at least one additional second fixation part and, if necessary, a further third fixation part for contacting the first part or the second part or any further part provided at or in the first housing part separately from the first part. The second fixation part and the first fixation part may be dimensioned differently or similar/identical to each other in terms of their relevant dimension for coming into contact with the first or second part to be fixed.

Specifically, the second fixation part may be positioned and dimensioned to be not in contact with the first part or the second part being placed at or in the first housing part when the fastener is not operated to fasten the second housing part to the first housing part but to be brought into contact with the first part or the second part being placed at or in the first housing part, when operating the fastener during the fastening process.

That is, the second fixation part may, similarly as the first fixation part, in an embodiment be already in contact with the first part to be mounted inside the first housing part when the fastening process is started by operating the fastener, in order to further support the pre-fixation of the first part inside the first housing part.

Alternatively, in another embodiment, the second fixation part may be dimensioned so as not to be in contact with the first part in a state where the first fixation part is (already) in contact with the first or the second part to be mounted to the first housing part.

According to a further aspect, the part assembly housing is configured such that during operation of the fastener in a first step, the first and/or the second fixation part is brought into contact with the first part, and in a second step, the second housing part is brought into contact with the first housing part.

This illustrates that the structure according to such an aspect allows to provide a kind of "multiple-step approach" of fixing a part inside a part assembly housing which may be designed in a suitable manner according to the specific requirements of the desired application case. Since in a first step, the first or second fixation part is brought into contact with the first or the second part during operation of the fastener, at this time, the first or second part is already kept in its position. Then, when in a second step the second housing part is brought into contact with the first housing part while further continuously deforming the second housing part to exert more resilient forces on the first or the second part, this second step is producing additional force to keep the already pre-fixed first or second part in its position in a more reliable long-lasting manner.

According to a further aspect, a second part to be fixed to the first housing part is provided at or in the first housing part and the second part is fixed in its position at or in the first housing part when the second housing part is fastened to the first housing part by the fastener.

That is, more than one part can be fixed to the first housing part by the structure of the part assembly housing according to the present application. For this purpose, the second housing part may comprise first, second or more fixation parts acting on the different respective parts to be fixed. Here, it is conceivable that the first and the second fixation part act on a first circuit board for example, to be fixed to the first housing part while a third fixation part acts on a second circuit board to be fixed to the same first housing part, subsequently or at the same time of fixation of the first printed circuit wiring board, as an example.

The first part and the second part may be arranged inside the first housing part in parallel to each other which is a suitable configuration in particular when the first and the second part are constituted by printed circuit wiring boards so that a space efficient arrangement of the PWBs inside the part assembly housing can be realized.

In one or more embodiments, a first and a second printed wiring circuit board may be arranged inside the first housing part in parallel to each other both being fixed in its position inside the part assembly housing by deformation of the second housing part. For this purpose, the first housing may have two fixation parts, one acting on the first PWB and the second one acting on the second PWB, for example.

In an arrangement of an embodiment, through holes may be formed in the upper PWB for the first fixation part to extend therethrough which may be coming into contact with the first part constituted by the upper PWB inside the first housing part. Here, the dimension of the through-holes in the upper PWB may be adapted to the diameter of the first fixation part to extend therethrough. This way, a fixation of the upper PWB is already realized by, for example, first fixation pins extending through the through holes, thereby fixing the PWB in its position against any unintentional movement. At the time before starting to operate the fastener, these fixation pins extending through the through holes may be in contact or not with the lower PWB.

This example illustrates that the first fixation part may principally act in a different manner to fix the part, e.g. the printed circuit wiring board, in or at the first housing part. While the present application is described by examples of pins exerting pressure force on the PWB or extending through through-holes of a PWB, the application is not limited to such kind of interaction between the fixation part and the part to be fixed in the position inside the part assembly housing and other ways of fixing the part in its position are conceivable easily for the skilled person in the art.

By suitably dimensioning first and second fixation parts in accordance with the parts to be fixed inside the bottom housing, an effective approach is provided to fix different parts at different points in time inside the part assembly housing by operating the same fastener which leads to an elastic deformation of, for example, a cover part constituting the second housing part.

In some embodiments, a counterpart may be arranged in the first housing part such that the first part is fastened between the counterpart and the first fixation part and/or the second fixation part. This configuration may improve the fixation of the part inside the part assembly housing. In some of these embodiments, this counterpart may be adapted to the shape of the part to be fixed in view of geometry, and dimension and positioning.

In additional embodiments, second counterparts are provided at the first housing part for fixing the second part in its position between the first or second fixation part and the second counterpart. This means that the counterpart may be provided for several parts to be fixed inside the part assembly housing and may be adapted differently with regard to shape and dimensions to keep the respective parts in position in dependence on the shape and the dimension of the parts to be fixed.

Whilst the present application is explicitly mentioning the first and the second part to be fixed inside the part assembly housing, the invention is not limited thereto and, in principle, more than two parts may be fixed inside the part assembly housing by utilizing merits of the present invention. Obviously, the same relates to the fixation parts and the counterparts which are not limited in number, either, and it is within the scope of the present disclosure that several fixation parts and counter parts are used for just one part to be fixed and that the part assembly as well as configurations were respective fixation parts and counterparts are provided for each part to be fixed inside the housing, if necessary.

The present application also provides a method of assembling a part assembly housing comprising a first housing part, a second housing part, a first part, and a second part. The method may comprise the following steps:
A first step of placing the second housing part above the first housing part such that a first fixation part provided in the second housing part contacts the first part, a first gap remains between a second fixation part provided in the second housing part for contacting the second part, and a second gap remains between the second housing part and the first housing part; a second step of fastening a fastener connecting the second housing part with the first housing part such that the second fixation part contacts the second part and the second gap is reduced; and a third step of further fastening the fastener whereby the second housing part is deformed such that the second housing part contacts the first housing part and a resilient force acting on the first fixation part and the second fixation part to be pressed on the first part and on the second part for fixation in or at second housing part is generated.

This method is particularly applicable to mount printed circuit wiring boards to a housing or a box and allows a fixation of two parts or more by use of the same fastener operation. Specifically, over the period of the fastening operation, the two parts are subsequently fixed at different points in time, while the elastic force generated by deforming the second housing part is continuously generated. Since the different parts are fixed at different points in time, it is possible to keep the required tolerances of positioning the different parts at different positions inside the part assembly housing. This is due to the fact that the stepwise fixing of the different parts allows for a better control of the fixation operation as a whole, since the points of time of fixing the different parts inside the part assembly housing are separated from each other and, are thus, easier to control. This is because in cases where one part is not appropriately fixed, it would be impossible to modify its fixation, since this would influence the fixation of the other part (the second part), as well, if it is fixed at the same point in time. Here, the approach described herein provides a significant improvement by carrying out the fixation stepwise at different points in time.

### BRIEF DESCRIPTION OF THE DRAWINGS

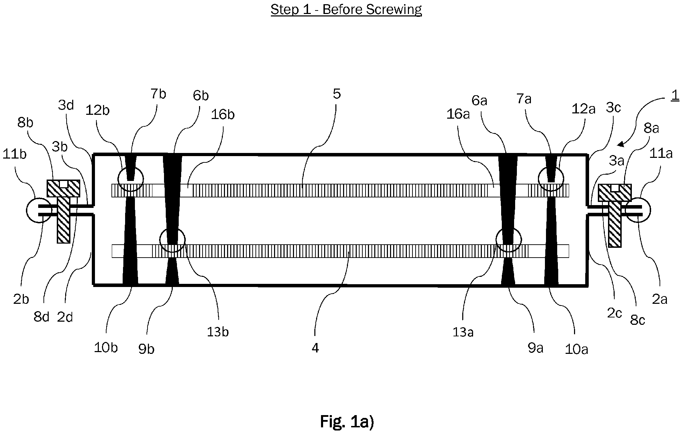

Figures 1a-c schematically illustrate an embodiment of a part assembly housing and steps of assembling a part assembly housing.

### DETAILED DESCRIPTION OF THE INVENTION

The present application generally relates to a part assembly housing which in the present description is exemplified as an electronic housing for accommodating therein two printed circuit wiring boards. It should, however, be understood that the following detailed description is intended illustrative, rather than limiting, and the invention is not limited to electronic part applications and may be applied to any application where it is necessary to mount one or more parts to a box or a housing or the like.

An embodiment of the part assembly housing and of the method of assembling the part assembly housing is described in the following in more detail with reference to Figs. 1a-c.

In Fig. 1a, a part assembly housing 1 is shown as an embodiment comprising a lower first housing 2 and a cover part 3 which are mounted to each other in order to close the housing after assembling the parts inside the housing. For this purpose, both, the bottom part 2 and the cover part 3 comprise at their side faces laterally outwardly extending collar sections 2a, 2b and 3a, 3b, respectively. These lateral collar sections 2a, 2b and 3a, 3b are arranged in parallel to each other forming gaps 11a and 11b, respectively, therebetween.

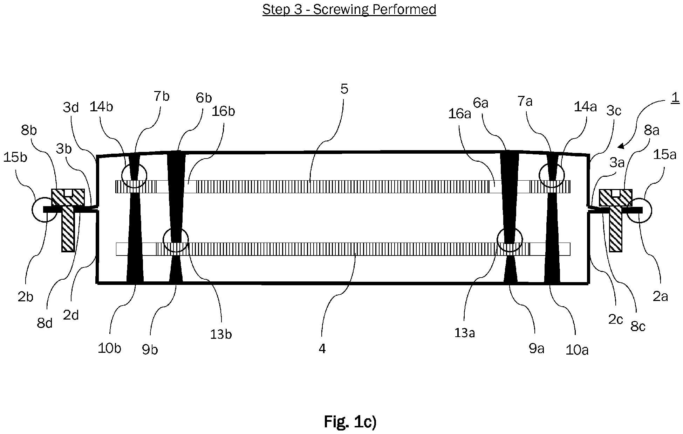

Screws 8a and 8b are provided by means of which the gaps 11a, 11b can be closed when the screws are operated to be screwed into sections 2a, 2b and 3a, 3b to bring these lateral collar parts 2a, 2b and 3a, 3b, in contact with each other, as shown in Fig. 1c, to form contact portions 15a and 15b, respectively.

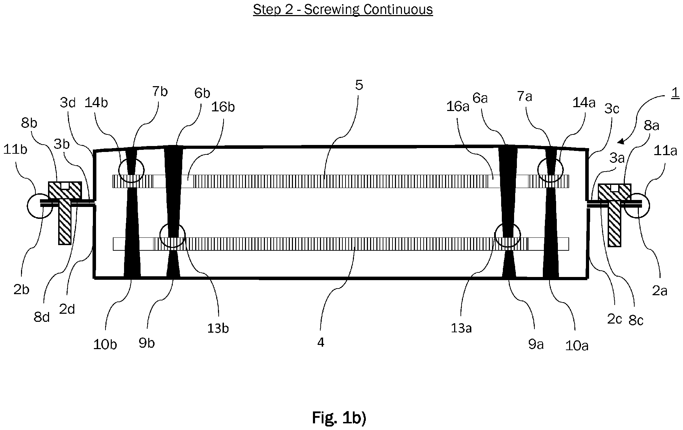

Fig. 1b illustrates an intermediate position where gaps 11a and 11b are still present with a reduced distance between sections 2a and 3a, and 2b and 3b, respectively. The geometry and dimensions of the bottom part 2 and the second housing part 3 are adapted to each other in such a way that by putting the two parts together, a closed housing box is obtained.

In the present embodiment two printed circuit wiring boards 4, 5 are provided inside the housing or box 1. The printed circuit wiring boards 4, 5 are placed in the lower housing part 2 before the cover housing part 3 is placed on the bottom part 2. More specifically, the lower printed circuit wiring board 4 is placed on inner counterparts 9a, 9b, while the upper printed circuit wiring board 5 is placed on outer counterparts 10a, 10b. In this position, both printed circuit wiring boards 4, 5 are not yet finally fixed in the position inside the lower housing part 2.

When the cover part 3 is placed on the lower housing part 2, as illustrated in Fig. 1a, the fixation pins 6a and 6b, and 7a and 7b, respectively, provided at the inner side of the cover housing part 3 are extending downwards towards the printed circuit wiring boards 3 and 4, respectively.

In more detail, fixation pins 6a and 6b are abutting on the upper side of the lower printed circuit wiring board 4 so as to form contact portions 13a and 13b, respectively, while gaps 12a and 12b remain between the lower end of fixation pins 7a, 7b and the upper side of the upper printed wiring circuit board 5, at the stage illustrated in Fig. 1a.

Through-holes 16a and 16b are provided in the upper printed circuit wiring board 5 through which fixation pins 6a, 6b extend. As a result, a certain pre-arrangement of the upper printed circuit wiring board is realized, as it is prevented to slide laterally and to collide with the inner side surfaces of cover housing part 3.

Referring to Fig. 1b, when the screws 8a, 8b are screwed to the lower housing part 2, the lower end faces 8c and 8d of the screw heads of screws 8a and 8b come into abutment with the upper face of sections 3a and 3b, respectively, so as to exert a compressive stress on sections 3a and 3b, respectively. As a result, the second housing part 3, which may be formed of magnesium, is bent in its outer side portions outside the region where the fixation parts 6a and 6b are attached to the inner side of the cover 3.

Due to this bending effect of elastic deformation of the second housing part, the size of gaps 11a and 11b are further reduced as the screwing process continues as illustrated in Fig. 1b. At a certain stage, while reduced gaps 11a, 11b still being present, contact portions 14a and 14b are formed between the lower end of fixation parts 7a, 7b, and the upper side of the upper printed circuit wiring board 5. At this time, the upper printed circuit wiring board is fixed in its position through the compressive force applied by elastic deformation of the cover housing part 3 and transferred via the fixation parts 7a, 7b to the printed wiring circuit boards 4, 5.

With the ongoing screwing process, the gaps 11a, 11b are further decreased and the fixation pressure applied by the fixation parts 6a, 7a and 6b, 7b on the printed boards 4, 5 is continuously increased to further fix the lower printed circuit wiring board 4 and the upper printed circuit wiring board 5 in their positions inside the housing 1.

At the stage illustrated in Fig. 1c, the printed circuit wiring boards 4 and 5 are reliably fixed in their position as gaps 11a and 11b are closed to bring sections 2a and 3a, and 2b and 3b in contact with each other to result in contact portions 15a and 15b, respectively.

The features described in the above description, claims and figures can be relevant to the invention in any combination. Their reference numerals in the claims have merely been introduced to facilitate reading of the claims. They are by no means meant to be limiting.

Throughout this specification various indications have been given as to embodiments of the invention. However, it should be understood that the invention is not limited to any one of these. It is therefore intended that the foregoing detailed description be regarded as illustrative rather than limiting, and that it be understood that it is the appended claims, including all equivalents, that are intended to defined the sprit and scope of this invention.

## Claims

1. Part assembly housing (1) comprising:
- a first housing part (2) at or in which at least a first part (4) to be fixed to the first housing part (2) is provided; and
- a second housing part (3) comprising at least a first fixation part (6) for fixing the first part (4), the second housing part (3) being configured to be fastened to the first housing part (2) by a fastener (8),
wherein the second housing part (3) has a structure to generate a resilient force acting on the first part (4) via the first fixation part (6) in such a manner that the first part (4) is fixed in its position at or in the first housing part (2), when the second housing part (3) is fastened to the first housing part (2) by the fastener (8).

2. Part assembly housing (1) according to claim 1, wherein the housing is configured such that the first fixation part (6) is in contact with the first part (4) being placed at or in the first housing part (4), at the time when the second housing part (3) is fastened to the first housing part (2) by starting to operate the fastener (8).

3. Part assembly housing (1) according to claim 1, wherein the part assembly housing (1) is structured such that the fastening force exerted by the fastener (8) onto the second housing part (3) is increased gradually by operating the fastener (8) during the fastening process, whereby the second housing part (3) is continuously deformed to increase the resilient force acting onto the at least one first part (4) via the at least first fixation part (6) to fix the at least one first part (4) in its position at or in the first housing part (3).

4. Part assembly housing (1) according to claim 1, wherein the fastener (8) comprises at least one screw arranged to fasten the first housing part (2) to the second housing part (3).

5. Part assembly housing (1) according to one of the preceding claims, wherein the second housing part (3) has a lower young's modulus than the first housing part (2) and/or the first part (4) to be fixed to the first housing part (2).

6. Part assembly housing (1) according to one of the preceding claims, wherein the second housing part (3) has a lower young's modulus than the first fixation part (6).

7. Part assembly housing (1) according to one of the preceding claims, wherein the second housing part (3) comprises at least a second fixation part (7) for contacting the first part (4) or for contacting a second part (5) provided separately from the first part (4) at or in the first housing part (2).

8. Part assembly housing (1) according to one of the preceding claims, wherein the second housing part (3), the at least one first fixation part (6) and/or the at least one second fixation part (7) are adapted to each other with regard to shape and dimension and positioning at the second housing part (2) such that, in a first deformation state of the second housing part (3) at least one of the first and/or second fixation part(s) is in contact with a first or a second part (4, 5) to be fixed inside the first housing part (2) and, in a second deformation state of the second housing part (3), at least one additional first and/or second fixation part(s) (6, 7) is in contact with a first or a second part (4, 5) to be fixed inside the first housing part (2).

9. Part assembly housing (1) according to claim 6, wherein the at least second fixation part (7) is dimensioned so as not to be in contact with the first part (4) or the second part being placed at or in the first housing part (4), when the fastener (8) is not operated to fasten the second housing part (3) to the first housing part (2), but so as to be brought into contact with the first part (4) or the second part (5) placed at or in the first housing part (4), when operating the fastener (8) during the fastening process.

10. Part assembly housing (1) according to one of the preceding claims, wherein the part assembly housing (1) is configured such that during operation of the fastener (8) in a first step the first or the second fixation part is brought into contact with the first part (4), and in a second step the second housing part (3) is brought into contact with the first housing part (2) by continuous elastic deformation in dependence on the fastening force.

11. Part assembly housing (1) according to one of the preceding claims, wherein the second part (5) provided at or in the first housing part (2) separately from the first part (4) is fixed in its position at or in the first housing part (2), when the second housing part (3) is fastened to the first housing part (2) by the fastener (8).

12. Part assembly housing (1) according to at least one of the preceding claims, wherein the first part (4) and the second part (5) are arranged in parallel to each other.

13. Part assembly housing (1) according to at least one of the preceding claims, wherein through-holes (16 a, 16b) for the first fixation pins (6) are arranged in the second part (5).

14. Part assembly housing (1) according to at least one of the preceding claims, wherein a plurality of first counter pins (9) is arranged in the first housing part (2) such that the first part (4) is fastened between the plurality of first fixation pins (6) and the plurality of first counter pins (9).

15. Part assembly housing (1) according to at least one of the preceding claims, wherein a plurality of second counter pins (10) is arranged in the first housing part (2) such that the second part (5) is fastened between the plurality of second fixation pins (7) and the plurality of second counter pins (10).

16. Part assembly housing (1) according to at least one of the preceding claims, wherein the first part (4) and/or the second part (5) are printed wiring circuit boards.

17. Method of assembling a part assembly housing (1) comprising a first housing part (2), a second housing part (3), a first part (4), and a second part (5), the method comprising:
a first step of placing the second housing part (3) on the first housing part (2) such that a first fixation part (6) provided in the second housing part (3) contacts the first part (4), a first gap (12) remains between a second fixation part (7) provided in the second housing part (3) for contacting the second part (5), and a second gap (11) remains between the second housing part (3) and the first housing part (2);
a second step of fastening a fastener (8) connecting the second housing part (3) with the first housing part (2), such that the second fixation part (7) contacts the second part (5) and the second gap (11) is reduced; and
a third step of further fastening the fastener (8) whereby the second housing part (3) is deformed such that the second housing part (3) contacts the first housing part (2) and a resilient force acting on the first fixation part (6) and the second fixation part (7) to be pressed on the first part (4) and on the second part (5) for fixation in or at second housing part (3) is generated.

## Amended claims

### Amended claims in accordance with Rule 137(2) EPC.

1. Part assembly housing (1) comprising:
- a first housing part (2) at or in which at least a first part (4) to be fixed to the first housing part (2) is provided; and
- a second housing part (3) comprising at least a first fixation part (6) for fixing the first part (4), the second housing part (3) being configured to be fastened to the first housing part (2) by a fastener (8),
wherein the second housing part (3) has a structure to generate a resilient force acting on the first part (4) via the first fixation part (6) in such a manner that the first part (4) is fixed in its position at or in the first housing part (2), when the second housing part (3) is fastened to the first housing part (2) by the fastener (8), the second housing part (3) has a lower young's modulus than the first housing part (2) and/or the first part (4) to be fixed to the first housing part (2) or the second housing part (3) has a lower young's modulus than the first fixation part (6).

2. Part assembly housing (1) according to claim 1, wherein the housing is configured such that the first fixation part (6) is in contact with the first part (4) being placed at or in the first housing part (4), at the time when the second housing part (3) is fastened to the first housing part (2) by starting to operate the fastener (8).

3. Part assembly housing (1) according to claim 1, wherein the part assembly housing (1) is structured such that the fastening force exerted by the fastener (8) onto the second housing part (3) is increased gradually by operating the fastener (8) during the fastening process, whereby the second housing part (3) is continuously deformed to increase the resilient force acting onto the at least one first part (4) via the at least first fixation part (6) to fix the at least one first part (4) in its position at or in the first housing part (3).

4. Part assembly housing (1) according to claim 1, wherein the fastener (8) comprises at least one screw arranged to fasten the first housing part (2) to the second housing part (3).

5. Part assembly housing (1) according to one of the preceding claims, wherein the second housing part (3) comprises at least a second fixation part (7) for contacting the first part (4) or for contacting a second part (5) provided separately from the first part (4) at or in the first housing part (2).

6. Part assembly housing (1) according to one of the preceding claims, wherein the second housing part (3), the at least one first fixation part (6) and/or the at least one second fixation part (7) are adapted to each other with regard to shape and dimension and positioning at the second housing part (2) such that, in a first deformation state of the second housing part (3) at least one of the first and/or second fixation part(s) is in contact with a first or a second part (4, 5) to be fixed inside the first housing part (2) and, in a second deformation state of the second housing part (3), at least one additional first and/or second fixation part(s) (6, 7) is in contact with a first or a second part (4, 5) to be fixed inside the first housing part (2).

7. Part assembly housing (1) according to claim 1, wherein the at least second fixation part (7) is dimensioned so as not to be in contact with the first part (4) or the second part being placed at or in the first housing part (4), when the fastener (8) is not operated to fasten the second housing part (3) to the first housing part (2), but so as to be brought into contact with the first part (4) or the second part (5) placed at or in the first housing part (4), when operating the fastener (8) during the fastening process.

8. Part assembly housing (1) according to one of the preceding claims, wherein the part assembly housing (1) is configured such that during operation of the fastener (8) in a first step the first or the second fixation part is brought into contact with the first part (4), and in a second step the second housing part (3) is brought into contact with the first housing part (2) by continuous elastic deformation in dependence on the fastening force.

9. Part assembly housing (1) according to one of the preceding claims, wherein the second part (5) provided at or in the first housing part (2) separately from the first part (4) is fixed in its position at or in the first housing part (2), when the second housing part (3) is fastened to the first housing part (2) by the fastener (8).

10. Part assembly housing (1) according to at least one of the preceding claims, wherein the first part (4) and the second part (5) are arranged in parallel to each other.

11. Part assembly housing (1) according to at least one of the preceding claims, wherein through-holes (16 a, 16b) for the first fixation pins (6) are arranged in the second part (5).

12. Part assembly housing (1) according to at least one of the preceding claims, wherein a plurality of first counter pins (9) is arranged in the first housing part (2) such that the first part (4) is fastened between the plurality of first fixation pins (6) and the plurality of first counter pins (9).

13. Part assembly housing (1) according to at least one of the preceding claims, wherein a plurality of second counter pins (10) is arranged in the first housing part (2) such that the second part (5) is fastened between the plurality of second fixation pins (7) and the plurality of second counter pins (10).

14. Part assembly housing (1) according to at least one of the preceding claims, wherein the first part (4) and/or the second part (5) are printed wiring circuit boards.

15. Method of assembling a part assembly housing (1) comprising a first housing part (2), a second housing part (3), a first part (4), and a second part (5), the method comprising:
a first step of placing the second housing part (3) on the first housing part (2) such that a first fixation part (6) provided in the second housing part (3) contacts the first part (4), a first gap (12) remains between a second fixation part (7) provided in the second housing part (3) for contacting the second part (5), and a second gap (11) remains between the second housing part (3) and the first housing part (2);
a second step of fastening a fastener (8) connecting the second housing part (3) with the first housing part (2), such that the second fixation part (7) contacts the second part (5) and the second gap (11) is reduced; and
a third step of further fastening the fastener (8) whereby the second housing part (3) is deformed such that the second housing part (3) contacts the first housing part (2) and a resilient force acting on the first fixation part (6) and the second fixation part (7) to be pressed on the first part (4) and on the second part (5) for fixation in or at second housing part (3) is generated.
